# EUROPEAN PATENT APPLICATION

(11) **EP 3 503 212 A1**
(43) Date of publication of application: **26.06.2019**
(21) Application number: 18196763.9
(22) Date of filing: 26.09.2018
(51) Int. Cl.: H01L 31/042

(54) **SOLAR CELL PANEL AND BICYCLES USING THE SAME**

(30) Priority: 22.12.2017 CN 201721828796 U
(71) Applicant: Miasole Photovoltaic Technology Co., Ltd., 100107 Beijing (CN)
(72) Inventor: WEN, Junrong, Beijing, Beijing 100107 (CN); YANG, Sheng, Beijing, Beijing 100107 (CN); OU, Haijin, Beijing, Beijing 100107 (CN)
(74) Representative: Nony

(57) **Abstract**

Disclosed are a solar cell panel and a bicycle. The solar cell panel includes output busbars and a plurality of solar cell groups connected in parallel between the output busbars. Each of the solar cell groups includes a plurality of solar cell strings connected in series, and each of the solar cell strings includes a plurality of solar cells connected in series.

## Description

### TECHNICAL FIELD

The disclosure relates to the application field of solar cell panel, and particularly relates to a solar cell panel and a bicycle using the solar cell panel.

### BACKGROUND

A shared bicycle is an emerging shared economic product that appears in recent years, and is rapidly popular with consumers due to the advantages of convenience, environmental protection, low price and the like. Meanwhile, the shared bicycle also promotes rapid development of mobile new energy industry.

A solar cell panel for the shared bicycle is installed in a basket of the shared bicycle, but a surface of the solar cell panel is often partially covered or shielded by goods placed in the basket, reducing overall efficiency of the solar cell panel. With respect to the above problem of the solar cell panel used in the shared bicycle, an effective solution for ensuring overall generating efficiency of the solar cell panel and bringing convenient manufacture and simple structure is not presented currently.

### SUMMARY

The present disclosure provides a solar cell panel which is formed by segmenting a solar cell chip with large size and then restructuring it, so as to make up for deficiencies of the related art and disadvantages of related solutions.

A solar cell panel for a bicycle includes output busbars and a plurality of solar cell groups connected in parallel between the output busbars.

Each of the solar cell groups includes a plurality of solar cell strings connected in series, and each of the solar cell strings includes a plurality of solar cell connected in series.

The plurality of solar cell strings in one of the solar cell groups are arranged alternately with the plurality of solar cell strings in another one of the solar cell groups, the plurality of solar cell strings in the same one of the plurality of solar cell groups are spaced apart from each other.

In an exemplary embodiment, each of the solar cell strings has the same number of solar cells, and each of the solar cells has the same area.

In an exemplary embodiment, each of the solar cell groups has the same number of solar cell strings.

In an exemplary embodiment, the solar cells are arranged in multiple rows or multiple columns.

In an exemplary embodiment, electrodes of two adjacent solar cells located in the same row or the same column are connected through wire bonding or welding.

In an exemplary embodiment, electrodes of two solar cells located in different rows or different columns and connected in series are connected through a conducting apparatus.

In an exemplary embodiment, the conducting apparatus is a busbar or a wire.

In an exemplary embodiment, an electrical isolating apparatus is arranged between adjacent solar cells located in different rows or different columns.

In an exemplary embodiment, the electrical isolating apparatus is an insulating coating or an insulating spacer.

A solar cell panel for a bicycle includes output busbars and a plurality of solar cell groups connected in parallel between the output busbars.

Each of the solar cell groups includes a plurality of solar cell strings connected in series, and each of the solar cell strings includes a plurality of solar cells connected in series.

In an exemplary embodiment, the solar cell strings in adjacent solar cell groups are alternately arranged.

In an exemplary embodiment, each of the solar cell strings has the same number of solar cells, and the solar cells have a same area.

In an exemplary embodiment, the solar cell groups have the same number of solar cell strings.

In an exemplary embodiment, the solar cells are arranged in multiple rows or multiple columns.

In an exemplary embodiment, electrodes of two adjacent solar cells located in the same row or the same column are connected through wire bonding or welding.

In an exemplary embodiment, electrodes of two solar cells which are located in different rows or different columns and connected in series are connected through a conducting apparatus.

In an exemplary embodiment, the conducting apparatus is a busbar or a wire.

In an exemplary embodiment, an electrical isolating apparatus is arranged between adjacent solar cells located in different rows or different columns.

In an exemplary embodiment, the electrical isolating apparatus comprises one or more of an insulating coating, an insulating cement, an insulating strip, or an insulating spacer.

A bicycle includes the solar cell panel according to any embodiment.

The present disclosure provides a solar cell panel. A solar cell panel with a large size is divided into a plurality of solar cell groups connected in parallel, each solar cell group includes a plurality of solar cell strings connected in series, and each solar cell string includes a plurality of solar cells connected in series. The solar cell strings in each group are arranged alternately so that the solar cell strings in the same group are in a non-contact state. Compared with a solar cell panel with a same area, a multi-level scaled down solar cell chip structure can achieve a purpose of reducing generating current of each solar cell. Since the solar cells in the same group are arranged separately, a hot spot effect caused by shielding of a local region and a defect that reduces the overall absorption and conversion rate of the solar cell panel can be alleviated and even eliminated. When the disclosure achieves the above effects, other devices such as diodes and the like are not added, so the structure is more simple and is convenient for making arrangement according to actual needs.

### BRIEF DESCRIPTION OF DRAWINGS

FIG. 1 is a schematic diagram illustrating a solar cell panel according to an embodiment of the present disclosure.
FIG. 2 is an equivalent schematic diagram illustrating a solar cell panel according to an embodiment of the present disclosure.

### List of reference numerals:

100 output busbar; 1 solar cell string; 2 solar cell; and 3 conducting apparatus

### DETAILED DESCRIPTION

Embodiments of the present disclosure are described below in detail. Examples of embodiments are shown in drawings. In the drawings, same or like numerals refer to same or like elements throughout, or refer to elements with same or like functions.

The present embodiment provides a solar cell panel, which may be used in a bicycle. In an embodiment, the solar cell panel is arranged in a basket or a fender of the bicycle. The solar cell panel is configured to power an electrical device of the bicycle. The electrical device includes, but is not limited to, an intelligent lock and the like. The bicycle may be a shared bicycle, however, is not limited to the shared bicycle.

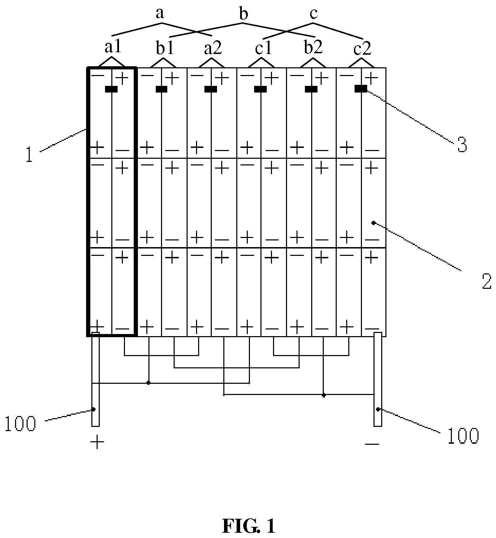

As shown in FIG. 1, the solar cell panel includes output busbars 100 and a plurality of solar cell groups (not shown) connected in parallel to the output busbars 100. Each of the solar cell groups includes a plurality of solar cell strings 1 connected in series. FIG. 1 illustrates a solar cell string 1 in a solar cell group with a bold solid box (the embodiment shown in FIG. 1 includes three solar cell groups a, b and c, and the solar cell group a includes a solar cell string a1 and a solar cell string a2, the solar cell group b includes a solar cell string b1 and a solar cell string b2, the solar cell group c includes a solar cell string c1 and a solar cell string c2). For a proper structure, the quantity of the solar cell strings 1 in each solar cell group may be identical. Meanwhile, each of the solar cell strings 1 includes a plurality of solar cells 2 connected in series. Similarly, for a proper layout of the solar cell panel, the quantity of the solar cells 2 in each solar cell string 1 may be identical, and an area of each solar cell 2 may also be identical. Of course, the quantity of the solar cell strings 1 in each solar cell group, the quantity of the solar cells 2 in each solar cell string 1, and the area of each solar cell 2 can be increased or decreased according to a size of the basket of the bicycle, loading condition and other specific conditions. The solar cell panel provided in this embodiment is configured in the following manner. The plurality of solar cell strings in the same solar cell group are spaced apart, and the solar cell strings 1 in one of the solar cell groups are arranged alternately with the solar cell strings 1 in another one of solar cell groups, so that the solar cell strings 1 in the same solar cell group do not neighbour each other, i.e., the solar cell strings 1 in the same solar cell group are spaced apart from each other. In an embodiment, the solar cell strings in a solar cell group are arranged alternately with the solar cell strings in an adjacent solar cell group. As shown in Fig. 1, the solar cell group a is adjacent to the solar cell group b, the solar cell strings a1 and a2 in the solar cell group a are arranged alternately with the solar cell strings b1 and b2 in the solar cell group b, such that the solar cell string a1 and the solar cell string a2 in the solar cell group a are spaced apart, and the solar cell string b1 and the solar cell string b2 in the solar cell group b are spaced apart. Likewise, the solar cell group b is adjacent to the solar cell group c, the solar cell strings b1 and b2 in the solar cell group b are arranged alternately with the solar cell strings c1 and c2 in the solar cell group c, such that the solar cell string c1 and the solar cell string c2 in the solar cell group c are also spaced apart.

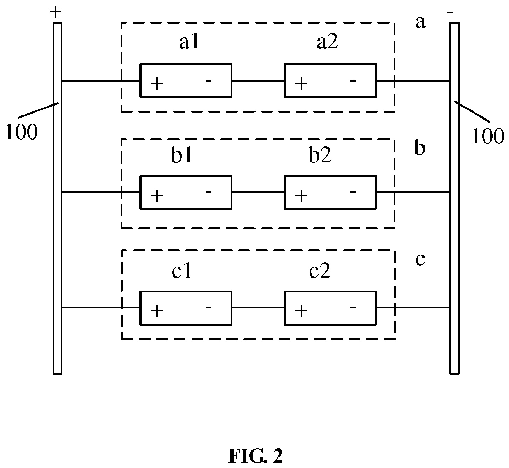

FIG. 2 is an equivalent schematic diagram illustrating a solar cell panel according to an embodiment of the present disclosure. As shown in FIG. 2, the solar cell groups a, b and c are enclosed by dashed boxes respectively. The solar cell group a includes the solar cell string a1 and the solar cell string a2 which are connected in series. The solar cell group b includes the solar cell string b1 and the solar cell string b2 which are connected in series. The solar cell group c includes the solar cell string c1 and the solar cell string c2 which are connected in series. The solar cell groups a, b and c are connected in parallel between the output busbars 100. In an embodiment, the magnitude of the current of the solar cell 2 depends on the width of the solar cell 2. As described in the above embodiments, the present disclosure employs a multi-level scaled down solar cell structure, that is, the sizes of a single solar cell 2 are reduced as small as possible so as to reduce the generating current of each solar cell 2, that is, so as to reduce the influence of an object that shields a part region of the solar cell panel on the overall performance of the solar cell panel. In conjunction with the configuration that the solar cell strings in the same solar cell group are spaced apart, the plurality of solar cell strings 1 in the same solar cell group are spaced apart, thereby alleviating and even eliminating a hot spot effect caused by shielding of a part region and a poor overall absorption and conversion rate of the whole solar cell group and the whole solar cell panel caused by shielding of a part region. On this basis, the plurality of solar cells 2 are connected in series, the plurality of solar strings 1 are connected in series, and the plurality of solar cell groups are connected in parallel, such that the voltage and current of the solar cell panel can be flexibly increased and reduced on the whole.

In an embodiment, the solar cells 2 may be arranged in multiple rows or multiple columns, and for example, arranged in multiple columns as shown in FIG. 1. As shown in FIG. 1, each solar cell 2 is tightly close to other solar cells 2, so as to sufficiently utilize a space. Electrodes of two adjacent solar cells 2 located in the same column or the same row (for the row arrangement, reference can be made to the column arrangement) may be electrically connected through wire bonding or welding. Since at least one layer of glue film is laminated on a surface of the chip when the solar cell panel is manufactured, it is sufficient to ensure stability of electrical connection of the solar cells 2.

Electrodes of two solar cells 2 located in different columns and connected in series are connected through a conducting apparatus 3, and for example, are electrically connected through a metal busbar or a wire and the like. In an embodiment, to ensure electrical safety, an electrical isolating apparatus may be arranged between adjacent solar cells 2 which are located in different columns and not electrically connected in series. In practical operation, an insulating coating, insulating cement or insulating spacer/strip and the like may be used as the electrical isolating apparatus.

In an embodiment, the solar cell panel may be a crystalline solar cell panel and a thin film solar cell panel. The crystalline solar cell panel has a low cost and a high photovoltaic conversion efficiency, and is suitable for generating electricity under outdoor sunlight. The thin film solar cell panel has a high cost, a photovoltaic conversion efficiency lower than the photovoltaic conversion efficiency of the crystalline solar cell panel. However, the thin film solar cell panel has a better weak light effect, and can generate power under the light of the common lamp.

The solar cell panel in the related art may be shielded by an object when being used, the solar cell shielded by the object panel cannot generate current and becomes a load consuming the power generated by other solar cell panels. In addition, the solar cell shielded by the object may generate heat, and such phenomenon is called a "hot spot effect". The solar cell panel will be damaged is the hot spot effect is severe, causing that the solar cell panel cannot work normally.

In the solar cell panel in this embodiment, the solar cell groups are connected in parallel and the voltage is stable, it is ensured that the solar cell panel can power the battery normally when a part of the solar cell panel is shielded, and the charging current is not reduced. Even being shielded by an object, the solar cell panel of this embodiment can keep a stable voltage and further charges the device. In addition, the solar cell groups are connected in parallel, so the charging current is increased, and the solar cell panel may maximum the charging current when not being shielded

The present disclosure provides a solar cell panel. A solar cell panel with a large size is divided into a plurality of solar cell groups connected in parallel, each solar cell group includes a plurality of solar cell strings connected in series, and the solar cell string includes a plurality of solar cells connected in series. The solar cell strings in the groups are arranged alternately so that the solar cell strings in the same group are in a non-contact state. Compared with a solar cell panel with a same area, a multi-level scaled down solar cell chip structure can reduce generating current of each solar cell. Since the solar cells in the same group are arranged separately, a hot spot effect caused by shielding of a local region and a defect that reduces the overall absorption and conversion rate of the solar cell panel can be alleviated and even eliminated.

## Claims

1. A solar cell panel for a bicycle, comprising output busbars (100) and a plurality of solar cell groups (a; b; c) connected in parallel between the output busbars (100),
wherein each of the solar cell groups (a; b; c) comprises a plurality of solar cell strings (1; a1; a2; b1; b2; c1; c2) connected in series, and each of the solar cell strings (1; a1; a2; b1; b2; c1; c2) comprises a plurality of solar cells (2) connected in series; and
the plurality of solar cell strings (a1; a2) in one (a) of the solar cell groups are alternately arranged with the plurality of solar cell strings (b1; b2) in another one (b) of the solar cell groups, and the plurality of solar cell strings (a1; a2) in the same one (a) of the solar cell groups are spaced apart from each other.

2. The solar cell panel according to claim 1, wherein each of the plurality of solar cell strings (1; a1; a2; b1; b2; c1; c2) has the same number of solar cells (2), and each of the plurality of solar cells has the same area.

3. The solar cell panel according to claim 2, wherein the solar cells (2) are arranged in multiple rows or multiple columns.

4. The solar cell panel according to claim 3, wherein an electrical isolating apparatus is arranged between adjacent solar cells (2) located in different rows or different columns.

5. A solar cell panel for a bicycle, comprising: output busbars (100) and a plurality of solar cell groups (a; b; c) connected in parallel between the output busbars (100),
wherein each of the solar cell groups (a; b; c) comprises a plurality of solar cell strings (1; a1; a2; b1; b2; c1; c2) connected in series, and each of the solar cell strings (1; a1; a2; b1; b2; c1; c2) comprises a plurality of solar cells (2) connected in series.

6. The solar cell panel according to claim 5, wherein the solar cell strings (a1; a2; b1; b2) in adjacent solar cell groups (a; b) are alternately arranged.

7. The solar cell panel according to claim 5 or claim 6, wherein each of the solar cell strings (1; a1; a2; b1; b2; c1; c2) has the same number of solar cells (2), and each of the solar cells (2) has the same area.

8. The solar cell panel according to claim 7, wherein each of the solar cell groups (a; b; c) has the same number of solar cell strings (a1; a2; b1; b2; c1; c2).

9. The solar cell panel according to claim 8, wherein the solar cells (2) are arranged in multiple rows or multiple columns.

10. The solar cell panel according to claim 9, wherein electrodes of two adjacent solar cells (2) located in the same row or the same column are connected through wire bonding or welding.

11. The solar cell panel according to claim 9, wherein electrodes of two solar cells (2) which are located in different rows or different columns and connected in series are connected through a conducting apparatus (3).

12. The solar cell panel according to claim 11, wherein the conducting apparatus (3) is a busbar or a wire.

13. The solar cell panel according to any of claims 9 to 12, wherein an electrical isolating apparatus is arranged between adjacent solar cells located in different rows or different columns.

14. The solar cell panel according to claim 13, wherein the electrical isolating apparatus comprises one or more of an insulating coating, an insulating cement, an insulating strip, or an insulating spacer.

15. A bicycle, comprising: the solar cell panel according to any of claims 1 to 4, or the solar cell panel according to any of claims 5 to 14.
